# EUROPÄISCHE PATENTSCHRIFT

(11) **EP 0 401 488 B1**
(45) Veröffentlichungstag und Bekanntmachung des Hinweises auf die Patenterteilung: **10.05.1995**
(21) Anmeldenummer: 90106686.0
(22) Anmeldetag: 06.04.1990
(51) Int. Cl.: C23C 14/02, C23C 14/06, C23C 14/08, C23C 28/00, C23C 14/22

(54) **Verfahren zur Herstellung hochharter Schichten auf Titanwerkstoffen sowie ihren Legierungen**
Process for producing high-hardened coatings on titanium materials and their alloys
Procédé pour la préparation de revêtements très durs sur des matériaux en titane et leurs alliages

(30) Priorität: 07.06.1989 DE 3918562
(43) Veröffentlichungstag der Anmeldung: 12.12.1990
(73) Patentinhaber: Repenning, Detlev, Dr., D-21465 Reinbek (DE)
(72) Erfinder: Repenning, Detlev, Dr., D-21465 Reinbek (DE)
(74) Vertreter: Niedmers, Ole, Dipl.-Phys.

(56) Entgegenhaltungen:
- EP-A- 0 320 706
- US-A- 4 762 756
- PATENT ABSTRACTS OF JAPAN, unexamined applications, C Sektion, Band 11, Nr. 75,6. März 1987 THE PATENT OFFICE JAPANESE GOVERNMENT Seite 100 C 408

## Beschreibung

Die Erfindung betrifft ein Verfahren hochharter Schichten auf Titanwerkstoffen und Titanlegierungen, bei welchem Verfahren der Werkstoff zunächst diffusionsgehärtet und anschließend unter Anwendung des PVD-Verfahrens mit wenigstens einer Hartstoffschicht versehen wird.

Für viele Zwecke, beispielsweise im Prothesenbau, zur Herstellung künstlicher Herzklappen, im Kraftfahrzeugbau für die Herstellung von Zulaßventilen und in vielen anderen Bereichen der Technik findet Titan Anwendung, da es unter anderem derart korrosionsbeständig ist, daß es sogar rostfreien Stahl an Korrosionbeständigkeit übertrifft. Für die genannten Anwendungszwecke aber auch für viele andere Bereiche der Technik wird neben hervorragender Korrosionsbeständigkeit gefordert, daß der Titanwerkstoff zudem zumindest im Bereich der Oberflächen hochhart auszubilden ist, um dem Titanwerkstoff (elementares Titan, Titanlegierungen) neben seiner natürlichen Korrosionsbeständigkeit auch hochharte Eigenschaften zu geben, um ebenfalls eine hohe Verschleißfestigkeit zu erreichen.

Es ist bekannt, Titanwerkstoffe dafür im unmittelbaren, grenznahen Bereich zur Oberfläche zu härten. Dieser Härtungsvorgang wird in der Regel durch ein an sich bekanntes Diffusionshärteverfahren erreicht, mit dem maximale Härten von 1200 bis 1600 HV 0,01 erreicht werden. Für viele Anwendungszwecke sind die vorgenannten, mit dem Diffusionshärteverfahren erreichbare Härten des Titanwerkstoffes nicht ausreichend, obwohl grundsätzlich mit dem Diffusionshärteverfahren verhältnismäßig große Schichtdicken im grenznahen Bereich zur Oberfläche des Titanwerkstoffes erreichbar sind. Ein weiterer wesentlicher Nachteil des bekannten Diffusionshärteverfahrens besteht darin, daß man bei der Ausführung des Diffusionshärteverfahrens keine gezielten Eigenschaften der grenznahen Oberflächenschicht einstellen kann, d.h. das Diffusionshärteverfahren gestattet in der Regel keine äußere Einflußnahme auf die Ausbildung der Härte der grenzflächennahen Schicht.

Aus der US-A-4,762,756 ist ein Verfahren bekannt, bei dem ein Werkstoff, beispielsweise eine Titanlegierung, zunächst diffusionsgehärtet und anschließend mit einer zusätzlichen Hartstoffschicht versehen wird. Die Hartstoffschicht kann beispielsweise durch das PVD-Verfahren und/oder das CVD-Verfahren aufgetragen werden. Durch das Auftragen der Hartstoffschicht mittels des PVD-Verfahrens auf dem diffusionsgehärteten Werkstoff wird bewirkt, daß eine an sich negative Grundeigenschaft der mittels eines PVD-Verfahrens normalerweise hergestellten Schicht, nämlich einer geringen Eintragfähigkeit bei hoher Belastung, bedingt durch die sehr geringen Schichtdicken der Hartstoffschicht, nicht mehr zum Tragen kommt. Die Hartstoffe können dabei grundsätzlich auf der Basis von Boriden, Carbiden, Nitriden, Oxiden oder hartem Kohlenstoff und ihren Gemischen oder dergl. hergestellt werden, sind also beliebig wählbar, je nach Einsatzart.

Die Verwendung derartiger Hartstoffe als Schichtstoffe, die mittels des PVD-Verfahrens aufgetragen werden, hat den Nachteil, daß die dadurch gebildeten Schichten nicht immer den gestellten Anforderungen, insbesondere bei extremen Reibungs- und/oder Hitze- und/oder Korrosionsbelastungen, genügen. Derartige Belastungen treten beispielsweise bei Ventilen oder Ventilsitzen eines Kraftfahrzeugmotors oder bei Prothesen in der Medizintechnik auf.

Es ist Aufgabe der vorliegenden Erfindung, ein Verfahren zur Herstellung von Schichten auf Titanwerkstoffen und Titanlegierungen zu schaffen, die hochhart und verschleißfrei und reibarm sind, so daß die Schichten auch höchsten Hitze-, Korrosions- und Reibungsbelastungen standhalten. Dabei soll das Verfahren derart führbar sein, daß die Eigenschaft der erzielten Schichten einstellbar und ohne Einschränkung reproduzierbar ist.

Gelöst wird die Aufgabe der Erfindung dadurch, daß die mittels des PVD-Verfahrens aufgebrachte Schicht aus Titan-Niobnitrid oder Titan-Nioboxid oder Titan-Hafniumcarbid oder Titan-Aluminiumnitrid besteht. Die Verwendung derartiger Materialen hat den Vorteil, daß beispielsweise eine Schicht aus Titan-Hafniumcarbid hochharte, verschleißfeste und hitzebeständige Eigenschaften aufweist, so daß ein derart beschichteter Werkstoff für Ventile oder Ventilsitze in einem Kraftfahrzeugmotor Verwendung finden können. Durch die Verwendung von Titan-Aluminiumnitrid wird eine hochverschleißfeste Schicht gebildet, die sich beispielsweise zum Einsatz in Gelenken von künstlichen Gliedern eignet. Durch das Auftragen einer Titan-Niobnitridschicht können Schichten mit großer Härte erzeugt werden. Durch die Beschichtung des Werkstoffes mit einer Titan-Nioboxidschicht wird eine gute Verträglichkeit mit dem menschlichen Organismus erreicht.

Bei einer vorteilhaften Ausgestaltung des Verfahrens erfolgt die Diffusionshärtung mittels des Ionennitrierverfahrens oder des Ionenborierverfahrens, es kann aber gesagt werden, daß grundsätzlich sämtliche Ionenhärteverfahren zur Ausführung der Diffusionshärtung des Titanwerkstoffes möglich sind.

Dabei erfolgt die Diffusionshärtung vorzugsweise bei Temperaturen in einem Temperaturbereich von 400°C bis 900°C. Es sei darauf hingewiesen, daß das vorerwähnte Temperaturintervall eine geringfügige Beeinflussung der Ausbildung der Eigenschaften der grenzflächennahen Oberflächenschicht im Titanwerkstoff gestattet. Diese Variationsmöglichkeit steht aber in keinem Verhältnis zur Einstellbarkeit der Eigenschaften des Schichtverbandes in seiner Gesamtheit, wie er mit dem erfindungsgemäßen Verfahren möglich ist.

Die mit der Diffusionshärtung erreichbaren Schichtdicken im oberflächennahen Grenzschichtbereich werden vorteilhafterweise zwischen 10⁻³ bis 5 x 10⁻¹mm gewählt, und zwar je nach den gewünschten Eigenschaften der mit dem erfindungsgemäßen Verfahren herzustellenden Schicht.

Als PVD-Verfahren kommen grundsätzlich alle bekannten PVD-Verfahren in Frage, vorzugsweise jedoch das Arc-Ionplating-Verfahren, das Elektron-Beam-Ionplating-Verfahren, das Sputter-Verfahren und das Are-Ionplating-Verfahren.

Bei einer weiteren vorteilhaften Ausgestaltung des Verfahrens weisen die mittels des PVD-Verfahrens hergestellten Schichten eine Schichtdicke im Bereich von 10⁻³ bis 3 x 10⁻²mm auf, wobei aber darauf hinzuweisen ist, daß auch andere Schichtdicken, insbesondere auch durch mehrfache Ausführung des PVD-Verfahrens, erreichbar sind, wobei die Mehrzahl der mit dem PVD-Verfahren herstellbaren Schichten mit gleicher PVD-Verfahrensführung, aber auch mit unterschiedlicher PVD-Verfahrensführung zur Erreichung unterschiedlicher physikalischer und chemischer Eigenschaften der einzelnen PVD-Schichten ausführbar sein können.

In einer weitergehenden Ausgestaltung der Erfindung wird mittels des PVD-Verfahrens zunächst eine Schicht aus Titan-Niobnitrid und anschließend eine Schicht aus Titan-Nioboxid aufgebracht. Ein derartig beschichteter Werkstoff kann in vorteilhafter Weise als Werkstoff für eine künstliche Herzklappe eingesetzt werden. Der diffusionsgehärtete Werkstoff weist durch die erste Titan-Niobnitridschicht eine hohe Härte auf, während durch die zweite Titan-Nioboxidschicht eine Schicht erzeugt wird, die eine hervorragende Blutverträglichkeit aufweist.

So wird beispielsweise allgemein in der Medizintechnik ein Kniegelenk heutzutage aus Titan bzw. einer Titanverbindung hergestellt, wobei das Gelenk in einer Gelenkpfanne aus Polyäthylen liegt und dort naturgemäß bei der Betätigung der Gelenke ständiger hoher Belastung durch Reibung ausgesetzt ist. Hinzu kommt das immerwährende Problem der Verträglichkeit der Werkstoffe der künstlichen Gliedmaßen mit dem biologischen Material, beispielsweise Blut, Gewebe, Knochen usw. Insbesondere ist das Problem der Korrosion von Metallen, auch des Titans, wenn auch in einen geringerem Maß als bei anderen Metallen, eine wesentliche Ursache für die Unverträglichkeit mit dem menschlichen Organismus.

Es wurde gefunden, daß eine Titan-Aluminium-Eisen-Legierung, die bei 800°C zunächst in einem Stickstoff-Wasserstoff-Gemisch diffusionsgehärtet wurde, und zwar mittels eines Ionennitrierverfahrens, auf der anschließend eine Titan-Aluminiumnitridschicht mit einer Härte von 1200 HV erzeugt wurde, hervorragende hochharte und verschleißfeste Eigenschaften erzielt wurden. Um die Korrosionsanfälligkeit vollständig zu unterbinden, wurde die Schicht anschließend mit einer zweiten, mittels des PVD-Verfahrens aufgebrachten Schicht aus Titannioboxid oder Titanniobnitrid, beschichtet, wobei dann die Schichthärte bei 2150 HV 0,01 bei einer Dicke von 5 x 10⁻³ mm lag. Die Diffusionstiefe, d.h. die Dicke der oberflächennahen Grenzschicht, die mittels des Diffusionshärteverfahrens hergestellt wurde, betrug dabei vorzugsweise 8 x 10⁻³ mm.

Zur Herstellung einer künstlichen Herzklappe wurde gefunden, daß eine Titanaluminiumverbindung, die im Diffusionshärteverfahren in einer Tiefe von 3 x 10⁻² mm gehärtet und anschließend mittels des PVD-Verfahrens beschichtet wurde, und zwar mit einer Schicht aus 3 x 10⁻³ mm Titan-Niobnitrid, die gewünschten hochharten Eigenschaften aufweist.Eine darauf mittels des PVD-Verfahrens aufgebrachte Schicht aus Titan-Nioboxid, führte zu hervorragenden blutverträglichen Eigenschaften. Bei der Ausbildung der zweiten, blutverträglichen Schicht aus Titan-Nioboxid beträgt der Sauerstoffanteil vorzugsweise ca. 66%, der Titananteil vorzugsweise ca. 30% und der Niobanteil vorzugsweise ca. 4%.

Zur Herstellung eines Einlaßventiles für einen Kraftfahrzeugmotor eignet sich Titan, da es extrem leicht ist und deshalb, im Gegensatz zu einer Stahllegierung, ein geringeres Trägheitsmoment aufweist, hervorragend. Das elementare Titan weist jedoch eine viel zu geringe Härteeigenschaft auf, so daß es zunächst erfindungsgemäß diffusionsgehärtet wurde, und zwar in einer Schichtdicke im Bereich von 6 x 10⁻² bis 10⁻¹ mm. Anschließend wurde das Titan mit einer 8 x 10⁻³ mm dicken Titanhafniumcarbidschicht mittels des PVD-Verfahrens beschichtet, mit dem eine hochtemperaturstabile und eine hochverschleißfeste Schicht auf dem Titan hergestellt wurde, die zudem noch hochhart ist. Es wurden Härtegrade von 3750 HV 0,01 bei einer derartigen Schichtkonstellation erreicht.

Die vorangehend aufgeführten Beispiele sind lediglich als Beispiele für eine sehr große Anwendungspalette des erfindungsgemäßen Verfahrens anzusehen. Einer der wesentlichen Vorteile des erfindungsgemäßen Verfahrens liegt darin, daß die Schicht auf dem Titanwerkstoff in Verbindung mit der oberflächennahen Grenzschicht des Werkstoffes, die diffusionsgehärtet wird, die Ausbildung von Schichten erlaubt, die je nach Belieben variierbar sind, um dieser Schicht die gewünschten chemischen und/oder physikalischen Eigenschaften, wie sie gewünscht werden, zu geben. Diese Variationsbreite in bezug auf die chemischen und/oder physikalischen Eigenschaften war bisher, vergl. oben, bei Titanwerkstoffen nicht möglich.

Auch die mittels des PVD-Verfahrens herstellbaren Schichten, die zwar teilweise erhebliche Härten aufweisen können, sind selbst wenig geeignet, die gewünschten chemischen und/oder physikalischen Eigenschaften zu erreichen, da die PVD-Schichten verhältnismäßig dünn sind und somit keine Eintragfähigkeit bei hoher Belastung besitzen. Die Grundmaterialien, nämlich Titanwerkstoffe auf denen die Schichten des PVD-Verfahrens ausgebildeten Schichten aufgebracht werden, besitzen nämlich in der Regel nur eine Härte zwischen 200 bis 400 HV.

Erst das erfindungsgemäße Verfahren, in dem das Diffusionsverfahren mit dem PVD-Verfahren kombiniert wurde, war in der Lage, die erfindungsgemäß gestellt Aufgabe zu lösen.

## Patentansprüche

1. Verfahren zur Herstellung hochharter Schichten auf Titanwerkstoffen und Titanlegierungen, bei welchem Verfahren der Werkstoff zunächst diffusionsgehärtet und anschließend unter Anwendung des PVD-Verfahrens mit wenigstens einer Hartstoffschicht versehen wird, dadurch gekennzeichnet, daß die mittels des PVD-Verfahrens aufgebrachte Schicht aus Titan-Niobnitrid oder Titan-Nioboxid oder Titan-Hafniumcarbid oder Titan-Aluminiumnitrid besteht.

2. Verfahren nach Anspruch 1, dadurch gekennzeichnet, daß die Diffusionshärtung mittels eines Ionennitrierverfahrens oder eines Ionenborierverfahrens erfolgt.

3. Verfahren nach einem oder beiden der Ansprüche 1 oder 2, dadurch gekennzeichnet, daß die Diffusionshärtung bei Temperaturen in einem Temperaturbereich von 400°C bis 900°C erfolgt.

4. Verfahren nach einem oder mehreren der Ansprüche 1 bis 3, dadurch gekennzeichnet, daß die Diffusionshärtung in Schichtdicken im Bereich von 10⁻³mm bis 5 x 10⁻¹mm erfolgt.

5. Verfahren nach einem oder mehreren der Ansprüche 1 bis 4, dadurch gekennzeichnet, daß als PVD-Verfahren das Arc-Ionplating Verfahren Anwendung findet.

6. Verfahren nach einem oder mehreren der Ansprüche 1 bis 5, dadurch gekennzeichnet, daß als PVD-Verfahren das Elektron-beam-Ionplating Verfahren Anwendung findet.

7. Verfahren nach einem oder mehreren der Ansprüche 1 bis 6, dadurch gekennzeichnet, daß als PVD-Verfahren das Sputter Verfahren Anwendung findet.

8. Verfahren nach einem oder mehreren der Ansprüche 1 bis 7, dadurch gekennzeichnet, daß als PVD-Verfahren das Are-Ionplating Verfahren Anwendung findet.

9. Verfahren nach einem oder mehreren der Ansprüche 1 bis 8, dadurch gekennzeichnet, daß die mittels des PVD-Verfahrens hergestellten Schichten eine Schichtdicke im Bereich von 10⁻³mm bis 3 x 10⁻²mm aufweisen.

10. Verfahren nach einem oder mehreren der Ansprüche 1 bis 9, dadurch gekennzeichnet, daß die Titan-Nioboxidschicht einen Anteil von ungefähr 66% Sauerstoff, 30% Titan und 4% Niob aufweist.

11. Verfahren nach einem oder mehreren der Ansprüche 1 bis 10, dadurch gekennzeichnet, daß mittels des PVD-Verfahrens zunächst eine Schicht aus Titan-Niobnitrid und anschließend eine Schicht aus Titan-Nioboxid aufgebracht werden.

## Claims

1. Process for producing extremely hard coatings on titanium materials and titanium alloys, in which process the material is first diffusion hardened and is then coated with at least one hard material coating by means of the PVD process, characterized in that the coating applied by means of the PVD process consists of titanium niobium nitride or titanium niobium oxide or titanium hafnium carbide or titanium aluminium nitride.

2. Process according to Claim 1, characterized in that the diffusion hardening is carried out by means of an ionic nitration process or an ionic boronizing process.

3. Process according to one or both of Claims 1 or 2, characterized in that the diffusion hardening is carried out at a temperature range of 400°C to 900°C.

4. Process according to one or more of Claims 1 to 3, characterized in that the diffusion hardening is carried out in layer thicknesses in the range of 10⁻³mm to 5 x 10⁻¹mm.

5. Process according to one or more of Claims 1 to 4, characterized in that the arc ionplating process is used as the PVD process.

6. Process according to one or more of Claims 1 to 5, characterized in that the electron beam ionplating process is used as the PVD process.

7. Process according to one or more of Claims 1 to 6, characterized in that the sputter process is used as the PVD process.

8. Process according to one or more of Claims 1 to 7, characterized in that the are ionplating process is used as the PVD process.

9. Process according to one or more of Claims 1 to 8, characterized in that the coatings produced by the PVD process have a coating thickness in the range of 10⁻³mm to 3 x 10⁻²mm.

10. Process according to one or more of Claims 1 to 9, characterized in that the titanium niobium oxide coating consists of approximately 66% oxygen, 30% titanium and 4% niobium.

11. Process according to one or more of Claims 1 to 10, characterized in that firstly a coating of titanium niobium nitride and then a coating of titanium niobium oxide are applied by means of the PVD process.

## Revendications

1. Procédé de production de couches de haute dureté sur des matériaux à base de titane et des alliages de titane, dans lequel le matériau est tout d'abord durci par diffusion, puis muni d'au moins une couche de dure par application du procédé PVD, caractérisé en ce que la couche déposée par application du procédé PVD est composée de nitrure de titane-niobium ou d'oxyde de titane-niobium ou de carbure de titane-hafnium ou de nitrure de titane-aluminium.

2. Procédé selon la revendication 1, caractérisé en ce que le durcissement par diffusion s'effectue par application du procédé de nitruration ionique ou d'un procédé de boruration ionique.

3. Procédé selon une ou chacune des revendications 1 et 2, caractérisé en ce que le durcissement par diffusion s'effectue à des températures comprises dans l'intervalle de température de 400°C à 900°C.

4. Procédé selon une ou plusieurs des revendications 1 à 3, caractérisé en ce que le durcissement par diffusion s'effectue dans des épaisseurs de couche de l'intervalle allant de 10-3 mm à 5 x 10-1 mm.

5. Procédé selon une ou plusieurs des revendications 1 à 4, caractérisé en ce qu'on applique, comme procédé PVD, le procédé de plaquage ionique à l'arc.

6. Procédé selon une ou plusieurs des revendications 1 à 5, caractérisé en ce qu'on applique, comme procédé PVD, le procédé de plaquage ionique au faisceau d'électrons.

7. Procédé selon une ou plusieurs des revendications 1 à 6, caractérisé en ce qu'on applique, comme procédé PVD, le procédé de pulvérisation cathodique.

8. Procédé selon une ou plusieurs des revendications 1 à 7, caractérisé en ce qu'on applique, comme procédé PVD, le procédé de plaquage ionique Are.

9. Procédé selon une ou plusieurs des revendications 1 à 8, caractérisé en ce que les couches produites par application du procédé PVD présentent une épaisseur de couche de l'intervalle de 10-3 mm à 3 x 10-2 mm.

10. Procédé selon une ou plusieurs des revendications 1 à 9, caractérisé en ce que la couche d'oxyde de titane-niobium présente une proportion d'environ 66 % d'oxygène, 30 % de titane et 4 % de niobium.

11. Procédé selon une ou plusieurs des revendications 1 à 10, caractérisé en ce que, par application du procédé PVD, on dépose tout d'abord une couche de nitrure de titane-niobium puis une couche d'oxyde de titane-niobium.
